(19) **Europäisches Patentamt / European Patent Office / Office européen des brevets**

(11) **EP 3 157 054 B1**

(12) **EUROPEAN PATENT SPECIFICATION**

(45) Date of publication and mention
of the grant of the patent:
**24.03.2021 Bulletin 2021/12**

(51) Int Cl.:
**H01L 23/40** *(2006.01)*     **H01L 23/433** *(2006.01)*

(21) Application number: **15306616.2**

(22) Date of filing: **13.10.2015**

(54) **APPARATUS FOR REGULATING THE TEMPERATURE OF AN ELECTRONIC DEVICE IN A HOUSING, A METHOD AND AN ASSEMBLY**

VORRICHTUNG ZUR REGULIERUNG DER TEMPERATUR EINER ELEKTRONISCHEN VORRICHTUNG IN EINEM GEHÄUSE, VERFAHREN UND ANORDNUNG

APPAREIL, PROCÉDÉ ET ENSEMBLE POUR RÉGULER LA TEMPÉRATURE D'UN DISPOSITIF ÉLECTRONIQUE DANS UN BOÎTIER

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.04.2017 Bulletin 2017/16**

(73) Proprietor: **Alcatel Lucent**
**91620 Nozay (FR)**

(72) Inventors:
• **KELLY, Gerard**
**Galway (IE)**
• **FRIZZELL, Ronan**
**Dublin, 15 (IE)**
• **DONNELLY, Brian**
**Dublin, 15 (IE)**

(74) Representative: **Bryers LLP**
**7 Gay Street**
**Bath, Bath and North East Somerset BA1 2PH (GB)**

(56) References cited:
EP-A1- 0 673 065     EP-A1- 0 852 398
DE-A1- 19 537 633    DE-A1-102006 037 747
US-B1- 6 545 352     US-B1- 6 894 908

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

TECHNICAL FIELD

Aspects relate, in general to an apparatus for regulating the temperature of an electronic package, a method and an assembly.

BACKGROUND

Heat regulation of electronic devices is an important and challenging area. As devices become denser and the demands on equipment increases, the heat produced by devices can be significant and detrimentally effect operation and efficiency. For example, heat generated in optical/electronic interface devices, such as XFPs, SFPs and CFPs and so on must find a path to the surrounding air. Typically, around 50% of the thermal resistance between a high temperature optical/electronic interface device and the cooler ambient air is due to the contact resistance between the device and its heat sink

Contact between the device and the heat sink is currently made using a spring loaded clip. However, this does not typically supply enough pressure between the two components to achieve sufficiently low thermal resistances. This means that heat typically cannot be removed from the device quickly enough for future densely packed optical equipment to be viable. This is particularly challenging to address since the temperature of the device must typically be held below a certain level using a design that allows it to be easily plugged/unplugged for maintenance and repair without using specialised tooling or thermal pastes. As noted, overheating of devices is a limiting factor of telecom routing equipment as data rates move to 400 and ultimately to 1 000 Gb/s for example.

EP0852398A1 relates to an apparatus for heating and cooling an electronic device. The apparatus includes a heat sink and a temperature dependent loading device which brings the heat sink into thermal contact with the electronic device when an ambient temperature exceeds a threshold level.

DE 19537633 discloses a heat conductor that connects a part needing cooling with a cooling body. The conductor has a contact plate for taking the heat as it is pressed by a spring element to the part. As the temperature increases the spring pulls the contact plate to the part to increase the cooling effect.

DE102006037747A1 discloses a cooling device for an electrical element. The cooling device comprises a carrier to connect with the electrical element, where another cooling device is mounted to the cooling device in a temperature dependent and movable manner.

US6545352B1 relates to an assembly for mounting power semi-conductive modules to heat dissipaters. A clamp is provided comprising a spring beam that may comprise layers of different materials. A portion of the spring beam contacts a module, applying force to bias a heat-transmitting surface of the module against a heat sink. When the temperature increases, the spring beam expands to add additional clamping force to the module.

EP0673065 describes a cooling device for electronic structures, comprising a heat sink.

US6894904 describes a tape automated bonding package and a method for fabricating the same in which a chip is bonded to a tape carrier through thermal compression and heat sink is attached to the backside of the chip.

SUMMARY

According to an aspect, there is provided a clip as provided in claim 1. The clip can comprise multiple arms extending from the substantially flat portion between a pair of legs or multiple legs extending from the periphery thereof. At least one of the arms can include an inwardly extending, substantially central region.

According to an aspect, there is provided a method as provided in claim 5.

According to an aspect, there is provided a system as provided in claim 6.

BRIEF DESCRIPTION OF THE DRAWINGS

Embodiments will now be described, by way of example only, with reference to the accompanying drawings, in which:

Figure 1 is an exemplary schematic representation of an existing XFP clip;

Figure 2 is a schematic representation of a clip;

Figure 3 is a schematic representation of a bimetallic structure of length L and thickness t;

Figure 4 is a schematic representation of a clip according to an example; and

Figure 5 is a schematic representation of a clip according to an example.

DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Large numbers of devices, such as optical components in a telecommunications network infrastructure for example, use slot based input/output connectors in a face plate. These connections link the voice/data traffic from the network to optical or electrical modules on the main board where processing occurs. For ease of use, the connectors are typically field replaceable. That is, an operator can remove the device for replacement or repair without the use of specialised tooling. Generally, in order to accomplish this, modules slide into a housing or casing on a main circuit board or base structure and are connected to a heat sink using a metal spring. The spring force generated cannot be too large or the connectors would not be easily replaced. In addition, typically no thermal grease or other interface material is used between the module and the heat sink. This combination of low spring force and "dry" contact leads to a large thermal barrier between the optical module and the heat sink, which ultimately means the connector modules overheat often. This can affect product releases and/or increase product return rates. In general, the more devices on the face plate, the bigger the issue, which is especially important when one considers higher data rate products which require more densely packed input/output connectors.

According to an example, apparatus for regulating the temperature of an electronic device in a housing is provided. The apparatus includes a top portion including at least one bimetallic strip, which acts as an active component that bends or deflects according to temperature changes. For example, in the presence of heat, such that the temperature of the top portion exceeds a threshold temperature, the strip can deflect so as to increase the contact pressure between a heat sink and a device mounted in a housing, thus decreasing the thermal resistance with increasing temperature. In an example, the bimetallic strip comprises first and second metallic layers with respective different coefficients of thermal expansion so selected as to exert a pressure that is proportional to the temperature increase, thereby allowing more efficient cooling of the device, which can be an optical module for example, and this increases performance.

A compressible thermal interface material may also be employed between the heat sink and the heat source. As the temperature of the heat source increases, the bimetallic heat sink clip imparts proportionally higher pressure and compresses the thermal interface material, thus reducing the thermal resistance, allowing for increased performance.

The bimetallic strip contains two different materials that are bonded together. Due to the difference in mechanical properties between the materials used, the strip can be configured to deflect dependent on the surrounding temperature. The level of deflection and induced force from the strip is proportional to the temperature increase. The bimetallic strip can be designed to operate within the expected temperature range of the device in question, such as an optical module for example. When the temperature drops below a certain threshold level, the bimetallic strip will not exert any pressure on a heatsink allowing the module to be removed or replaced easily. When the temperature of the module increases, the bimetallic strip can be selected or configured so as to exert a contact force that increases in proportion to the temperature increase. The higher pressure ensures a better thermal interface, ultimately higher heat transfer rates and improved product performance.

That is, a strip can be configured so that it does not contact a heat sink until a threshold temperature has been reached for example. Accordingly, the strip would need to get to a specific temperature before it covered the distance from its rest position to the heat sink or before the force on a heat sink builds sufficiently for the clip to exert pressure on the heat sink causing it to contact a device or device housing (or causing an increase in the applied pressure on the device or device housing in the case that the strip is in contact with the heat sink when at rest). Some bimetallic structures can 'snap' through to different positions at specific temperatures. These have a threshold temperature of operation that leads to a specific configuration of the strip, the value of which would depend on the structures design (thicknesses of metal layers and shape of the structure) and this could be tailored to specific applications.

Thus, enhanced heat transfer from a heat sink that cools, for example, an optical interface module can be provided. This enhanced heat transfer leads to reduced overheating events in these optical modules which increases the reliability of the devices and reduces the return rate of these components. Additionally, this allows denser packing of optical modules in equipment. Currently densely packed optical modules suffer since the cumulative thermal loads of the devices can cause them to exceed design guidelines and can lead to increased failure rates. Enhanced heat transfer rates allow more effective cooling of electronic devices and enable equipment with more densely packed optical modules to be realised.

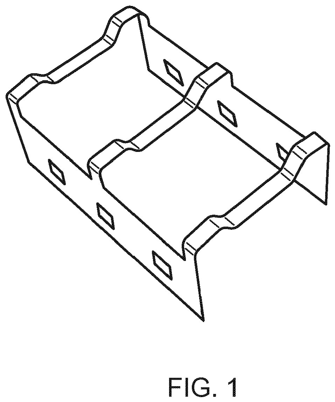

Figure 1 is an exemplary schematic representation of an existing XFP clip. XFP (10 Gigabit Small Form Factor Pluggable) is a standard for transceivers used in high-speed network and telecommunication links that use optical fiber. The clip is typically made from copper, stainless steel or aluminium. The shape is such that pressure is applied to the heat sink when an optical module is inserted. Mounting points enable the clip to be mounted to a base structure, and in the example of figure 1, the clip includes three top portions that exert a pressure against a device that is inserted into a housing. Typically, the housing includes a number of openings or windows. Respective top portions are arranged over the openings, and a heat sink arranged on the device protrudes through an opening and is held in place by a top portion.

The XFP clip is therefore in the form of a standard metal clip that is used to hold down a heat sink on an optical module. This is not an effective solution since the clip does not offer sufficient clamping pressure and leads to very high thermal resistance between the heat sink and the electronic device. The effect of increased thermal resistance is increased temperature in the optical module and reduced reliability of the optical equipment and network quality of service. The proposed solution offers significantly increased clamping pressure with increasing temperature that reduces this thermal resistance and enhances the reliability of electronic devices. By increasing the thermal performance of each electronic device individually more of these devices can be packed together increasing the number of devices per unit area in equipment.

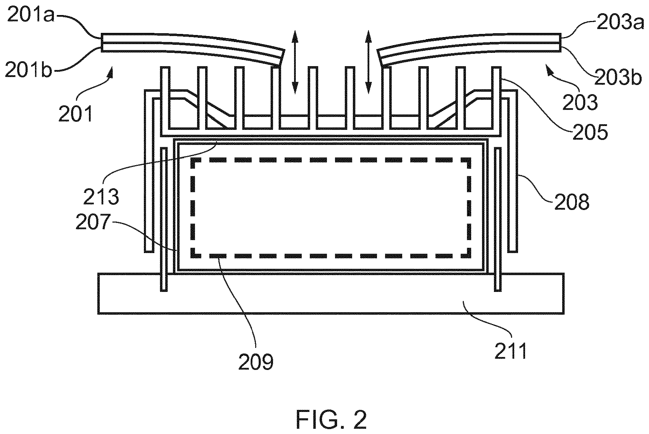

Figure 2 is a schematic representation of apparatus (not forming an embodiment). Bimetallic structures 201, 203 comprising first 201a, 203a and second 201b, 203b metallic layers with respective different coefficients of thermal expansion are provided. The bimetallic structures 201, 203 are configured to exert pressure on at least one heat sink 205 arranged on a housing 207 whereby to dissipate heat from the electronic device 209. The heat sink 205 is held in place on the housing 207 using a clip 208, which, in an example, can be a standard heat sink clip. The clip 208 generally contacts, and pushes down on, the heat sink 205. Optionally, a thermal interface material 213 can be disposed between the heat sink 205 and the electronic package being cooled. In this context, the electronic package is the combination of the electronic device 209 within the housing 207, but in some examples may just be an electronic device 209.

Thus, the bimetallic elements 201, 203 are employed to exert a force on the heat sink 205 and decrease the thermal resistance between the heat sink 205 and a heat source, which in the case of figure 2 is the electronic device (optical module) 209, which is provided on a base structure 211.

Additional bimetallic structures can be arranged over "hot spots" in the electronic package or at other points on the clip 208 such that the clip 208 will bend in such a way to add more pressure to the "hot spots".

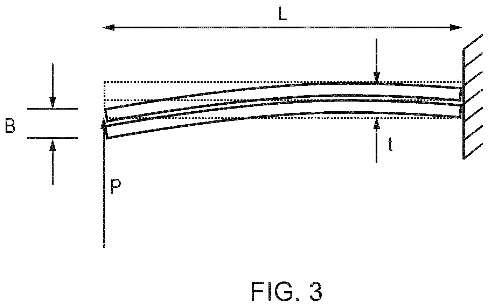

The bimetallic elements are configured to deflect according to the temperature of the electronic device. According to an example, and with reference to figure 3 (not forming an embodiment), which is a schematic representation of a bimetallic structure of length L and thickness t, the following equations can be used to design a bimetallic structure in order to induce a desired amount of deflection whereby to exert a desired level of force upon a heat sink or hot zone.

The thermal (linear) deflection, B, is calculated as follows:

$$B = \frac{a(T_2 - T_1)L^2}{t}$$

where t = material thickness, $(T_2 - T_1)$ = temperature change, L = active length of bimetallic structure and a = specific deflection.

The mechanical force, P, induced by a bimetallic structure is:

$$P = \frac{EBwt^3}{4L^3}$$

where E = elastic modulus and w = material width.

The thermal force, P, is therefore:

$$P = \frac{Ea(T_2 - T_1)wt^2}{4L}$$

Accordingly, a desired force to be exerted by a bimetallic structure can be set according to various parameters of the structure that can be selected taking into account the expected temperature range of the electronic device in question. For example, as noted above, when the temperature of the structure drops below or is at a certain level $T_1$, the bimetallic structure will not exert any pressure on the heatsink (such as being in a rest configuration in which it is just in contact with the heatsink or is displaced from the heatsink) allowing the module to be removed or replaced easily. When the temperature of the module increases, the bimetallic strip exerts a contact force that increases in proportion to the temperature increase. The higher pressure ensures a better thermal interface, ultimately higher heat transfer rates and improved product performance.

An example use case is for a bi-metallic heat sink clip incorporating a cantilever type bimetallic structure that is flat at typical room temperature of 22 °C ($T_1$). Consider that the beam is expected to rise to approximately 50 °C ($T_2$) when in contact with a heated optical module for example. The dimensions could be 3 mm thick, 5 mm in width and 25 mm long. A typical bimetallic beam from a commercial supplier has an elastic modulus of approximately 135 N/mm$^2$ and has a specific deflection of 2.08E-05 K$^{-1}$. Such a beam would apply approximately 35 N to the heat sink clip, which would increase the contact pressure and decrease the thermal resistance between the optical module and the heat sink.

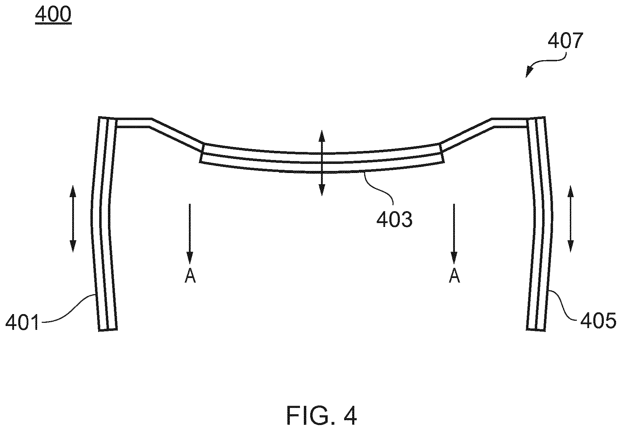

Figure 4 is a schematic representation of a clip according to an example. In the example of figure 4, bimetallic structures 401-405 are integrated into the clip 407 to exert a force on a heat sink and decrease the thermal resistance between the heat sink and heat source (not shown). This forms a bimetallic clip structure 400. As the temperature of the electronic device increases, the bimetallic structures bend as shown, whereby to exert a downward compression (direction A) upon a heat sink and heat source.

For example, the clip formed using one type of metal and a second metal layer with a different thermal expansion coefficient is bonded to the clip in specific locations in order to provide bimetallic structures at those locations. The locations are determined such that the deflection of the clip when heated compresses or extends the material of the clip so that a heat sink is forced down onto the hot component/optical module.

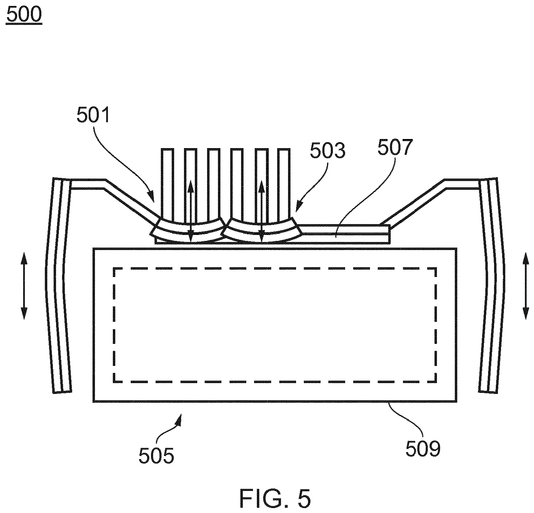

Figure 5 is a schematic representation of a clip according to an example. In the example of figure 5, one or more smaller bimetallic structures 501, 503 can be provided at known hot spots of an electronic device or package 505 in order to target problem areas that are known to suffer from significant heat issues. For example, it may be well known that a certain region of an electronic device experiences, in use, higher temperatures than other regions of the device due to, for example, the layout of internal components and/or the inability for an unimpeded airflow within that portion of the device. Accordingly, the temperature of this region can be regulated using a bimetallic structure 501 (and/or 503) in order to provide localized compression or localized exertion of a force that can be used in unison with an associated heat sink to enable more efficient dissipation of heat from the region. The clip with integrated bimetallic structures forms a bimetallic clip structure 500.

A compressible TIM (thermal interface material) 507 can be used at the interface between the clip and/or bimetallic structure and the housing 509. The TIM will compress most under the bimetallic elements affording increased heat flux removal at the hot spots.

The present inventions can be embodied in other specific apparatus and/or methods. The described embodiments are to be considered in all respects as illustrative and not restrictive. In particular, the scope of the invention is indicated by the appended claims rather than by the description and figures herein.

## Claims

1. A clip (407) configured to releasably secure an electronic package (505) and a heat sink (205) received in the clip, the clip comprising:
   at least one bimetallic structure (403) integrated in at least one side of the clip and comprising first and second metallic layers with respective different coefficients of thermal expansion, the bimetallic structure being configured to elastically deform to exert pressure on a heat sink in response to an increase in temperature whereby to dissipate heat from the electronic package, **characterised in that**:
   the clip comprises the first metallic layer, and the second metallic layer is bonded to the clip in specific locations in order to provide the bimetallic structure, the clip further comprising:

   at least one leg depending from the periphery of a flat portion, wherein the at least one leg includes at least one bimetallic structure (401, 405) comprising first and second metallic layers with respective different coefficients of thermal expansion, the at least one leg being configured to cause deformation in the clip when the leg is subjected to heat; and
   a compressible thermal interface material (507) arranged between the at least one heat sink and the electronic package at a specific location or in multiple locations, wherein the at least one bimetallic structure is configured to elastically deform above a predetermined threshold temperature whereby to exert or increase a contact pressure between the heat sink and at least one of: a portion of a housing (509) and the thermal interface material.

2. The clip as claimed in claim 1, wherein the flat portion includes multiple bimetallic structures (501, 503) arranged over a predetermined region of the electronic package, heat sink or a thermal interface material (507).

3. The clip as claimed in claim 1, wherein the clip comprises multiple arms extending from a flat portion between a pair of legs or multiple legs extending from the periphery thereof.

4. The clip as claimed in claim 3, wherein at least one of the arms includes an inwardly extending, central region.

5. A method for regulating the temperature of an electronic package, the method comprising:

   using a clip (407), releasably securing a heat sink (205) over at least a portion of the electronic package (505), the clip configured to receive the electronic package and the heat sink and maintain the heat sink in thermal contact with the electronic package;

increasing contact pressure between the heat sink and at least a portion of the electronic package by elastically deforming the clip using at least one bimetallic structure (403) comprising first and second metallic layers with respective different coefficients of thermal expansion, in response to raising the temperature of the or each bimetallic structure above a threshold temperature whereby to improve heat transfer from the electronic package, **characterised in that** the method comprises:

integrating the bimetallic structure in at least one side of the clip, wherein the clip comprises the first metallic layer, and the second metallic layer is bonded to the clip in specific locations in order to provide the bimetallic structure, the clip being configured to releasably secure the electronic package; selecting the first and second metallic layers so as to form the bimetallic structure being operable to exert or increase a contact pressure between the heat sink and at least one of: a portion of a housing (509) and a thermal interface material (507) arranged between the heat sink and the electronic package at a specific location or in multiple locations when the temperature of the structure reaches the threshold temperature.

6. System for regulating the temperature of an electronic package, the system comprising:

an electronic package (505);
a heat sink (205);
a clip (407) as claimed in any one of claims 1 to 4.

7. The system as claimed in claim 6, wherein the electronic package comprises an electronic device (209) received within a housing (509), wherein the housing includes the at least one opening.


**Patentansprüche**

1. Ein Clip (407), der so konfiguriert ist, dass eine elektronische Baugruppe (505) und ein Kühlkörper (205) im Clip lösbar gesichert sind, wobei der Clip umfasst:

mindestens eine bimetallische Struktur (403), die in mindestens eine Seite des Clips integriert ist und eine erste und zweite metallische Schicht mit jeweils unterschiedlichen Wärmeausdehnungskoeffizienten aufweist, wobei die bimetallische Struktur so konfiguriert ist, dass sie sich elastisch verformt, um Druck auf einen Kühlkörper als Reaktion auf einen Temperaturanstieg auszuüben, wodurch Wärme von der elektronischen Baugruppe abgeleitet wird, **dadurch gekennzeichnet dass**:

der Clip die erste metallische Schicht aufweist und die zweite metallische Schicht an bestimmten Stellen mit dem Clip verbunden ist, um die bimetallische Struktur bereitzustellen, wobei der Clip weiter umfasst:

mindestens einen Schenkel, der vom Umfang eines flachen Abschnitts absteht, wobei dieser mindestens eine Schenkel mindestens eine bimetallische Struktur (401, 405) bestehend aus der ersten und zweiten metallischen Schicht mit jeweils unterschiedlichen Wärmeausdehnungskoeffizienten besitzt, wobei dieser eine Schenkel so konfiguriert ist, dass der Clip verformt wird, wenn der Schenkel Wärme ausgesetzt ist; und
ein komprimierbares Wärmeleitmaterial (507), das zwischen mindestens einem Kühlkörper und der elektronischen Baugruppe an einer bestimmten Stelle oder an mehreren Stellen angeordnet ist, wobei die mindestens eine bimetallische Struktur so konfiguriert ist, dass sie sich über eine vorgegebene Schwellentemperatur elastisch verformt, wodurch ein Anpressdruck zwischen dem Kühlkörper und mindestens: einem Abschnitt eines Gehäuses (509) und dem Wärmeleitmaterial ausgeübt oder erhöht wird.

2. Der Clip nach Anspruch 1, wobei der flache Abschnitt mehrere bimetallische Strukturen (501, 503) aufweist, die über einem vorgegebenen Bereich von elektronischer Baugruppe, Kühlkörper oder Wärmeleitmaterial (507) angeordnet sind.

3. Der Clip nach Anspruch 1, wobei der Clip mehrere Arme aufweist, die von einem flachen Abschnitt zwischen einem Schenkelpaar oder mehreren Schenkeln ausgefahren werden, die wiederum von dessen Umfang ausgefahren werden.

4. Der Clip nach Anspruch 3, wobei mindestens einer der Arme einen innen ausfahrbaren zentralen Bereich aufweist.

5. Ein Verfahren zur Regulierung der Temperatur einer elektronischen Baugruppe, wobei dieses Verfahren umfasst:

Verwenden eines Clips (407), der einen Kühlkörper (205) über mindestens einen Abschnitt der elektronischen Baugruppe (505) lösbar sichert, wobei der Clip so konfiguriert ist, dass er die elektronische Baugruppe und den Kühlkörper enthält und ein Wärmekontakt zwischen Kühlkörper und elektronischer Baugruppe aufrechterhalten wird;
Erhöhen des Anpressdrucks zwischen dem Kühlkörper und mindestens einem Abschnitt der elektronischen Baugruppe durch elastisches Verformen des Clips unter Einsatz mindestens einer bimetallischen Struktur (403), die eine erste und zweite metallische Schicht mit jeweils unterschiedlichen Wärmeausdehnungskoeffizienten aufweist, als Reaktion auf einen Temperaturanstieg einer oder jeder bimetallischen Struktur über eine Schwellentemperatur, wodurch die Wärmeübertragung von der elektronischen Baugruppe verbessert wird, **dadurch gekennzeichnet dass** das Verfahren umfasst:

Integrieren der bimetallischen Struktur in mindestens eine Seite des Clips, wobei der Clip die erste metallische Schicht aufweist und die zweite metallische Schicht an bestimmten Stellen mit dem Clip verbunden ist, um die bimetallische Struktur bereitzustellen, wobei der Clip so konfiguriert ist, dass die elektronische Gruppe lösbar gesichert ist;
Auswählen der ersten und zweiten metallischen Schicht, sodass die bimetallische Struktur entsteht, die so einsetzbar ist, dass ein Anpressdruck zwischen dem Kühlkörper und mindestens: einem Abschnitt eines Gehäuses (509) und einem Wärmeleitmaterial (507) ausgeübt oder erhöht wird, das zwischen dem Kühlkörper und der elektronischen Baugruppe an einer bestimmten Stelle oder an mehreren Stellen angeordnet ist, wenn die Temperatur der Struktur die Schwellentemperatur erreicht.

6. System zur Regulierung der Temperatur einer elektronischen Baugruppe, wobei das System umfasst:

eine elektronische Baugruppe (505);
einen Kühlkörper (205);
einen Clip (407) nach einem beliebigen der vorstehenden Ansprüche 1 bis 4.

7. Das System nach Anspruch 6, wobei die elektronische Baugruppe eine elektronische Vorrichtung (209) innerhalb eines Gehäuses (509) aufweist, wobei das Gehäuse mindestens eine Öffnung besitzt.

## Revendications

1. Agrafe (407) configurée pour fixer de façon libérable un module électronique (505) et un dissipateur thermique (205) reçus dans l'agrafe, l'agrafe comprenant :

au moins une structure bimétallique (403) intégrée dans au moins un côté de l'agrafe et comprenant des première et deuxième couches métalliques ayant des coefficients de dilatation thermique respectifs différents, la structure bimétallique étant configurée pour se déformer élastiquement afin d'exercer une pression sur un dissipateur thermique en réponse à une augmentation de la température permettant la dissipation de chaleur provenant du module électronique, **caractérisée en ce que** :
l'agrafe comprend la première couche métallique, et la deuxième couche métallique est collée dans l'agrafe en des emplacements spécifiques pour former la structure bimétallique, l'agrafe comprenant en outre :

au moins une patte dépendant de la périphérie d'une partie plate, laquelle au moins une patte inclut au moins une structure bimétallique (401, 405) comprenant des première et deuxième couches métalliques ayant des coefficients de dilatation thermique respectifs différents, l'au moins une patte étant configurée pour provoquer une déformation dans l'agrafe quand la patte est soumise à de la chaleur ; et
un matériau d'interface thermique compressible (507) disposé entre l'au moins un dissipateur thermique et le module électronique en un emplacement spécifique ou en de multiples emplacements, où l'au moins une structure bimétallique est configurée pour se déformer élastiquement au-delà d'une température de seuil prédéterminée permettant qu'une pression de contact soit exercée ou augmentée entre le dissipateur thermique et au moins l'un parmi une partie d'un boîtier (509) et le matériau d'interface thermique.

2. Agrafe selon la revendication 1, dans laquelle la partie plate inclut de multiples structures bimétalliques (501, 503) disposées au-dessus d'une région prédéterminée du module électronique, du dissipateur thermique ou d'un matériau d'interface thermique (507).

3. Agrafe selon la revendication 1, laquelle agrafe comprend de multiples bras s'étendant depuis une partie plate entre une paire de pattes ou de multiples pattes s'étendant depuis la périphérie de celle-ci.

4.  Agrafe selon la revendication 3, dans laquelle au moins l'un des bras inclut une région centrale s'étendant vers l'intérieur.

5.  Procédé pour réguler la température d'un module électronique, le procédé comprenant :

    l'utilisation d'une agrafe (407), configurée pour fixer de façon libérable un dissipateur thermique (205) au-dessus d'au moins une partie du module électronique (505), l'agrafe étant configurée pour recevoir le module électronique et le dissipateur thermique et pour maintenir le dissipateur thermique en contact thermique avec le module électronique ;
    l'augmentation de la pression de contact entre le dissipateur thermique et au moins une partie du module électronique par déformation élastique de l'agrafe au moyen d'au moins une structure bimétallique (403) comprenant des première et deuxième couches métalliques ayant des coefficients de dilatation thermique respectifs différents, en réponse à l'élévation de la température de la ou de chaque structure bimétallique au-delà d'une température de seuil prédéterminée permettant une amélioration du transfert thermique depuis le module électronique, **caractérisé en ce que** le procédé comprend :

    l'intégration de la structure bimétallique dans au moins un côté de l'agrafe, où l'agrafe comprend la première couche métallique, et la deuxième couche métallique est collée à l'agrafe en des emplacements spécifiques afin que soit formée la structure bimétallique, l'agrafe étant configurée pour fixer de façon libérable le module électronique ;
    la sélection des première et deuxième couches métalliques de façon qu'elles forment la structure bimétallique opérable pour exercer ou augmenter une pression de contact entre le dissipateur thermique et au moins l'un parmi une partie d'un boîtier (509) et un matériau d'interface thermique (507) disposé entre le dissipateur thermique et le module électronique en un emplacement spécifique ou en de multiples emplacements quand la température de la structure atteint la température de seuil.

6.  Système pour réguler la température d'un module électronique, le système comprenant :

    un module électronique (505) ;
    un dissipateur thermique (205) ;
    une agrafe (407) telle que définie dans l'une quelconque des revendications 1 à 4.

7.  Système selon la revendication 6, dans lequel le module électronique comprend un dispositif électronique (209) reçu à l'intérieur d'un boîtier (509), dans lequel le boîtier inclus l'au moins une ouverture.

FIG. 1

FIG. 2

FIG. 3

FIG. 4

500

FIG. 5

**EP 3 157 054 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0852398 A1
- DE 19537633
- DE 102006037747 A1
- US 6545352 B1
- EP 0673065 A
- US 6894904 B